# EUROPEAN PATENT SPECIFICATION

(11) **EP 4 273 907 B1**
(45) Date of publication and mention of the grant of the patent: **11.03.2026**
(21) Application number: 23170401.6
(22) Date of filing: 27.04.2023
(51) Int. Cl.: H01L 21/48, H01L 23/495

(54) **METHOD OF MANUFACTURING SEMICONDUCTOR DEVICES**
VERFAHREN ZUR HERSTELLUNG VON HALBLEITERANORDNUNGEN
PROCÉDÉ DE FABRICATION DE DISPOSITIFS SEMI-CONDUCTEURS

(30) Priority: 03.05.2022 IT 202200008903
(43) Date of publication of application: 08.11.2023
(73) Proprietor: STMicroelectronics S.r.l., 20864 Agrate Brianza (MB) (IT)
(72) Inventor: FONTANA, Fulvio Vittorio, I-20052 Monza (Monza Brianza) (IT)
(74) Representative: Buzzi, Notaro & Antonielli d'Oulx S.p.A.

(56) References cited:
- US-A1- 2011 233 753
- US-A1- 2011 269 269
- US-A1- 2013 256 861

## Description

### Technical field

The description relates to semiconductor devices.

One or more embodiments can be applied to semiconductor devices such as integrated circuits (ICs), for instance.

### Background

In certain applications such as automotive applications, a satisfactory creepage distance between solder joints connected to battery and ground is a desirable feature for electrical modules assembled on a printed circuit board, PCB.

A satisfactory creepage distance facilitates avoiding short circuits (briefly, shorts) which may cause faulty operation, even fires on cars. Shorts can be related, for instance to surface mount technology, SMT assembly processes, for instance, due to flux residuals leading to copper migration or to conductive contaminants possibly left over on final products.

Creepage distance is a common designation for the shortest distance between two conductive parts over an insulating material. The value of that distance may be a function of an application voltage and can be defined in specifications such as, for instance, JEDEC memory standards for semiconductor memory circuits and similar storage devices (see jedec.org), standards such as DIN EN 60664 and/or in automotive customer specifications.

An approach to address issues related to creepage distance may involve removing contact leads from a full lead lay-out for a semiconductor device, thus increasing the spacing between critical contact leads connected to battery and ground.

A drawback of such an approach lies in that it involves customizing the leadframe and/or the substrate layout according to the associated pin list. This results in additional costs and lead-time issues.

Another approach, as discussed in Italian patent application 102020000012910, involves arranging at least one semiconductor chip on a substrate comprising an array of electrically conductive leads and electrically coupling the semiconductor chip to electrically conductive leads in the array. An electrically insulating encapsulation of the semiconductor chip arranged on the substrate is provided leaving the electrically conductive leads exposed at a surface of the encapsulation. Electrically insulating material such as solder resist material is then provided (e.g., via jet printing, aerosol printing, mesh printing or oxide growth) on selected ones of the electrically conductive leads exposed at the surface of the encapsulation.

While providing satisfactory results, such an approach may still be exposed to the risk that the electrically insulating material may be sensitive to scratches generated during handling and assembly steps.

Document US 2011/233753 A1 discloses a method of manufacture of an integrated circuit packaging system that includes: forming a paddle, an inner post adjacent to the paddle, a jumper pad, and an outer post, with the jumper pad between the inner post and the outer post; mounting an integrated circuit over a paddle first side, the paddle first side co-planar with the outer post; connecting a first jumper interconnect between the integrated circuit and the jumper pad; connecting a second jumper interconnect between the jumper pad and the outer post; and forming an encapsulation over paddle, the integrated circuit, the first jumper interconnect, the jumper pad, and the second jumper interconnect.

Document US 2011/233753 A1 is otherwise silent as to possibly removing a masking layer from electrically conductive formations after die mounting/wire bonding/molding. Also, Document US 2011/233753 A1 does not increase any creepage distance between adjacent pads, because the inner post is electrically connected to the outer post by a wire bond.

Document US 2019/385938 A1 discloses a semiconductor chip package device that includes: a lead frame, chips, an encapsulating layer, and an electroplating layer. The lead frame includes a first surface, a second surface, first grooves, second grooves, and third grooves. The first grooves are connected to the second grooves to form through holes and the third grooves disposed at ends of the lead frame. The chips are electrically connected to the lead frame. The encapsulating layer is formed by using an encapsulating material to encapsulate the chips and at least a portion of the lead frame. The first grooves are filled with the encapsulating material. An electroplating layer is disposed on the second surface of the lead frame, and extends into the third grooves or into the third grooves and the second grooves.

Document US 2019/385938 A1 does not disclose a masking layer already present on the bottom side of the substrate when the die is mounted.

Documents US 2011/269269 A1 and US 2013/256861 A1 are also of interest for the invention.

### Object and summary

An object of one or more embodiments is to contribute in providing improved solutions overcoming the drawbacks discussed in the foregoing.

Such an object can be achieved via a method having the features set forth in the claims that follow.

In a method as described herein, one or more semiconductor chips are arranged on a first surface of a substrate comprising electrically conductive formations such as an array of electrically conductive leads covered by a masking layer at a second surface, opposite the first surface. The semiconductor chip or chips are coupled to electrically conductive leads in the array and an insulating encapsulation is molded on the semiconductor chip or chips arranged on the first surface of the substrate. The masking layer is selectively removed, e.g., via laser ablation, from one or more of the electrically conductive leads (or other electrically conductive formations) that are thus left uncovered by the masking layer. Etching is applied to the second surface of the substrate so that the electrically conductive formations such as leads left uncovered by the masking layer are removed, thus increasing the creepage distance to other electrically conductive formations that are left in place.

One or more embodiments provide a solution to customize a standard pre-plated leadframe (e.g., a full array JEDEC Quad Flat No-lead, QFN leadframe).

After package molding and before back etching, the plating (e.g., few tens of nanometers of NiPdAu) is ablated with a laser at the location of the lead or leads to be removed, exposing the metal, e.g., copper, from the bulk of the substrate (leadframe). Then, during back etching, exposed (that is, unmasked) leads are etched away at the same time the other (masked) leads are "set free".

Solutions as discussed herein thus involve encapsulation molding followed by selective removal e.g., by laser ablation, of a masking layer (e.g., a pre-plating NiPdAu layer) provided at lead locations to expose the substrate metal (e.g., copper). Back-etching as applied to free the (masked) leads removes the exposed (unmasked) leads, thus increasing creepage distance as desired.

The resulting device will exhibit, at the locations where the exposed (unmasked) leads, are removed, recessed portions ("dimples") in the encapsulation that are easily detectable by naked-eye or optical microscope inspection. Also, laser machining used to selectively remove the masking layer (e.g., a pre-plating NiPdAu layer) may leave a trace in the molding compound of the encapsulation.

### Brief description of the several views of the drawings

One or more embodiments will now be described, by way of example only, with reference to the annexed figures, wherein:
Figure 1 is a partial view of a semiconductor device exemplary of a creepage distance therein;
Figure 2 is a complete view of a semiconductor device suited to be processed as discussed herein;
Figure 3 is a complete view of a semiconductor device that has been processed as discussed herein;
Figure 4 is a flow chart exemplary of a sequence of steps as discussed herein;
Figures 5 and 6 are partial perspective views of a semiconductor device illustrating certain steps of the sequence of Figure 4;
Figures 7A, 7B, 7C and 7D are partial cross-sectional views of a semiconductor device being processed as discussed herein; and
Figure 8 is a schematic representation of a system including semiconductor devices as described herein.

The figures are drawn to clearly illustrate the relevant aspects of the embodiments and are not necessarily drawn to scale.

Corresponding numerals and symbols in the different figures generally refer to corresponding parts unless otherwise indicated.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Throughout the figures, like parts or elements are indicated with like reference symbols, and a corresponding description will not be repeated for each and every figure for brevity.

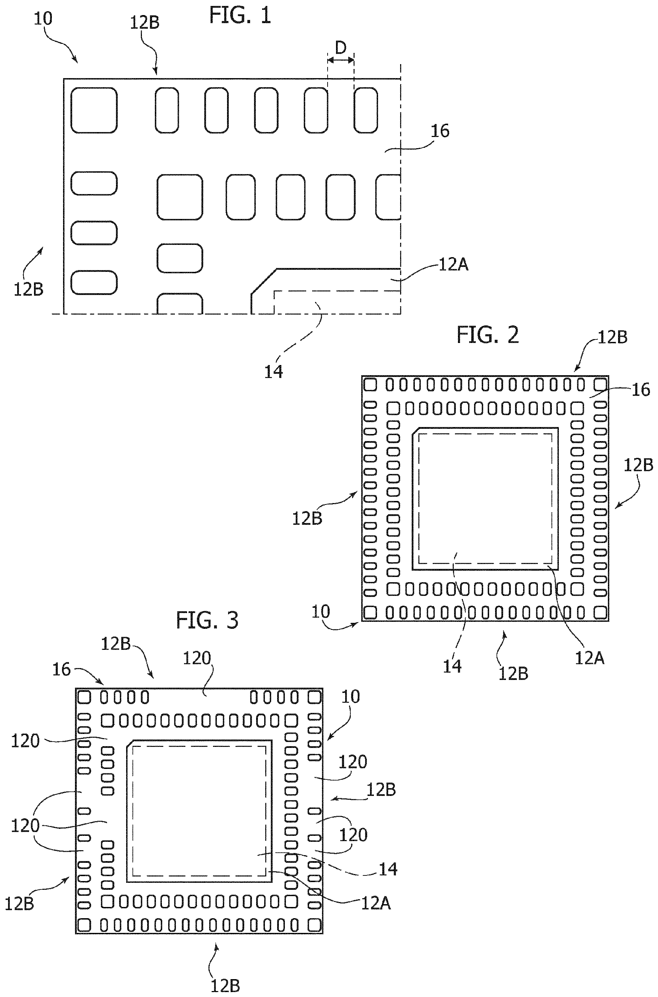

Figure 1 is a partial (rear or bottom) view of a semiconductor device 10 of the Quad Flat No-lead, QFN type.

This type of device is just exemplary of a variety of semiconductor devices where a creepage distance having (at least) a certain minimum value D between electrically conductive formation such as leads represents a feature to pursue. Consequently, the embodiments are not limited to the possible use in QFN semiconductor devices.

As conventional in the art, a device 10 as exemplified herein may comprise a substrate such as a so-called lead frame (or leadframe) including a die pad 12A and an array of electrically conductive leads 12B around the die pad 12A.

The leads 12B are intended to provide electrical contact according to a desired routing pattern for one or more semiconductor chips or dice 14 arranged on a die arranging area of the die pad 12A.

Part of the outline of such a chip or die 14 (only one is considered here for simplicity) is illustrated in dashed lines in Figures 1 to 3.

The designation lead frame (or leadframe) is currently used (see, for instance the USPC Consolidated Glossary of the United States Patent and Trademark Office) to indicate a metal frame which provides support (here at 12A) for a semiconductor chip or die (here 14) as well as electrical leads (here 12B) to couple the semiconductor chip or die to other electrical components or contacts.

Essentially, a leadframe comprises an array of electrically conductive formations (such as the leads 12B) which from a peripheral location extend inwardly in the direction of the semiconductor chip or die 14, thus forming an array of electrically conductive formations from the die pad 12A configured to have at least one semiconductor chip or die attached thereon. This may be via a die attach adhesive (a die attach film or DAF, for instance).

It is noted that the indication "No-leads" referred to a QFN device as depicted herein is not in contradiction with such a package comprising an array of leads such as 12B: in fact, the indication "No-leads" is related to the fact that a QFN package is substantially exempt from external (distal) tips of the leads in the leadframe 12 projecting radially outwardly of the package.

In a conventional arrangement as exemplified in Figure 2, a packaged semiconductor device 10 includes:
a metal leadframe 12A, 12B,
at least one semiconductor chip or die 14 attached onto a die pad 12A in the leadframe,
bond wires or like electrically conductive formations (not visible in the figure) that electrically connect bonding pads on the chip or die 14 to individual leads 12B of the leadframe, and
hard insulating encapsulant material 16 (for instance a molding compound plastic resin such as an epoxy resin), that covers the other components and forms the exterior of the package.

The leadframe 12A, 12B provides the supporting structure for the placement of the semiconductor die or dice 14, in particular during assembly of the packaged device, and external contactors.

As noted, the foregoing is conventional in the art, which makes it unnecessary to provide a more detailed description herein.

Figure 1 is exemplary of the possible existence, in a semiconductor device such as the device 10, of a creepage distance D, namely a shortest distance between two conductive parts (here two leads 12B) over an insulating material such as the encapsulant package material 16.

Figure 2 is exemplary of a semiconductor device 10, wherein a creepage distance (see the distance D in Figure 1) is desired to be formed between two conductive parts such as leads 12B. To that effect one or more leads 12B should desirably be "removed" at one or more locations such as the locations indicated by way of example by the references 120 in Figure 3.

As discussed, a satisfactory creepage distance is a desirable feature in order to avoid short circuits (shorts): it will be otherwise appreciated that, while a creepage distance between leads 12B is primarily referred to herein for simplicity, the same criteria apply to providing a desired creepage distance between electrically conductive formations at least one of which is not a lead.

As discussed, an approach to address this issue would involve removing this or these "undesired" contact leads from a full lead lay-out for a semiconductor device (see Figure 2) by customizing that substrate layout according to an associated pin list.

This would result in undesirable additional costs and lead-time issues.

Another possible approach, as discussed in Italian patent application 102020000012910 (already cited) involves coating the undesired leads with electrically insulating material such as solder resist. As noted, such an electrically insulating material may be sensitive to scratches generated during handling and assembly steps, which can be regarded as a drawback.

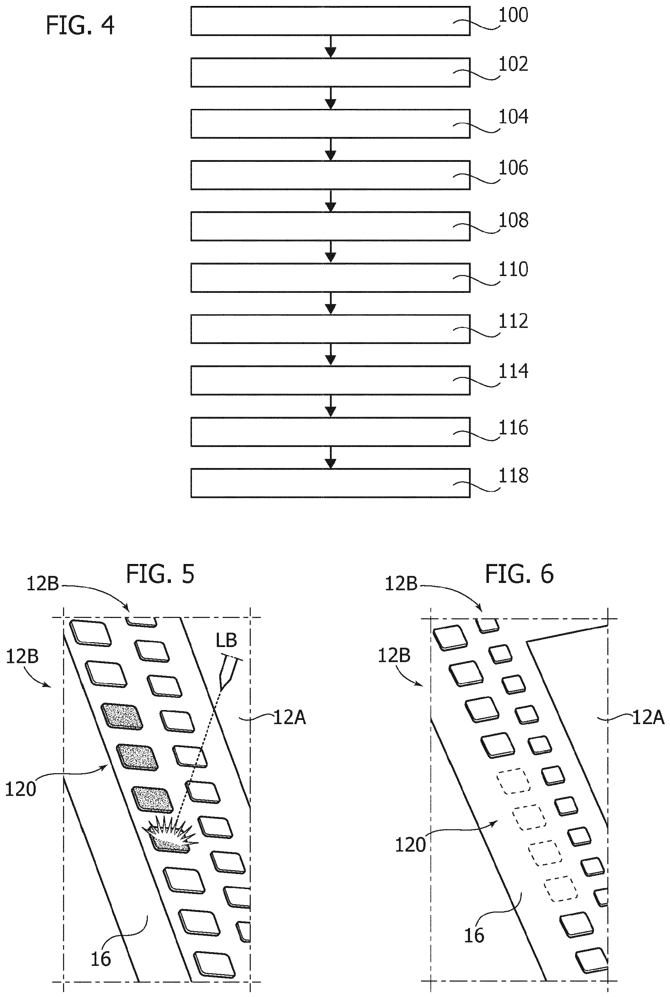

The flow chart of Figure 4 is exemplary of possible steps or actions involved in manufacturing a semiconductor device such as the device 10 by adequately addressing these issues.

Those of skill in the art will otherwise appreciate that a manufacturing method as exemplified herein may include various additional (sub)steps which are not visible in Figure 4 for simplicity and/or variations of the steps described, e.g., as a function of the technologies involved and/or specific features of the products manufactured. That is, while advantageous, the whole exact sequence of steps illustrated in Figure 4 is not strictly mandatory for the embodiments, provided an ordered sequence is maintained of the steps of:
i) arranging one or more semiconductor chips on a first surface of a substrate comprising electrically conductive formations covered by a masking layer at a second surface, opposite the first surface,
ii) providing an insulating encapsulation of the semiconductor chip(s) arranged on the first surface of the substrate,
iii) removing the masking layer from one or more of the electrically conductive formations at the second surface of the substrate wherein the electrically conductive formation(s) is/are left uncovered by the masking layer, and
iv) applying etching to the second surface of the substrate wherein the electrically conductive formation(s) left uncovered by the masking layer is/are removed.

As exemplified in Figure 4, a manufacturing method as considered herein comprises - as exemplified in block 100 - providing a substrate (a metal leadframe 12A, 12B, for instance). This may be in the form of a continuous strip used for manufacturing plural devices to be finally separated or "singulated" as exemplified by block 118 discussed in the following.

Also, it will be assumed that the leadframe 12A, 12B is of a pre-plated type (pre-plated frame, PPF, as conventional in full array JEDEC QFNs) that is with a plating of NiPdAu (nickel, palladium and gold) or the like, applied on the back or bottom surface.

The back or bottom surface is the surface opposed to the front or top surface onto which the semiconductor chip or chips 14 are mounted. The plating is provided (in a manner known per se to those of skill in the art) at least at those locations where conductive leads 12B (or other electrically conductive formations) may be intended to be provided.

The wording "may" takes into account the fact that a solution as described herein is intended to facilitate ultimately providing leads 12B only at certain ones of these locations, while one or more "undesired" leads can be selectively "removed".

Block 102 in Figure 4 is exemplary of attaching on the front or top surface of the leadframe (at the die pad 12A, for instance) at least one semiconductor chip or die (e.g., 14).

This is followed (in block 104) by providing a wire bonding pattern (or the like) that electrically connects bonding pads on the chip or die 14 to individual leads (e.g., 12B) of the leadframe.

Block 106 is exemplary of molding an insulating package material 16 (e.g., epoxy resin) onto the assembly thus formed, and block 108 is exemplary of post mold curing of the encapsulation formed by the insulating package material 16 thus molded.

To summarize, the steps or actions 100 to 108 are exemplary of arranging at least one semiconductor chip 14 on a first surface of a substrate (die pad 12A plus leads 12B).

The substrate comprises an array of electrically conductive formations (e.g., leads 12B) that are covered by a masking layer 1200 (e.g., NiPdAu) at a second surface opposite the first surface.

The semiconductor chip or chips 14 are electrically coupled (e.g., via a wire bonding pattern, not visible for simplicity) to selected ones of the leads 12B in the array of electrically conductive leads.

An insulating encapsulation 16 (e.g., an epoxy resin) is molded on the semiconductor chip or chips 14 arranged on the first surface of the substrate (leadframe) 12A, 12B,

The steps or actions 100 to 108 are otherwise conventional in the art, which makes it unnecessary to provide a more detailed description herein.

The block 110 in Figure 4 is exemplary of a step where, as represented in Figure 5, laser beam energy LB is applied to remove (laser ablate) the (e.g., NiPdAu) plating layer at that location or those locations 120 where electrically conductive formations such as the leads 12B are desired to be removed.

The block 112 in Figure 4 is exemplary of back etching (e.g., chemical or plasma etching) where the metal material (e.g., copper) of the leadframe is etched away (again in a manner known per se to those of skill in the art) in order to "free" the leads 12B at those locations of the leadframe material that are covered by the (e.g., NiPdAu) plating.

Conversely, those regions or areas of the leadframe material (e.g., copper) that are left exposed by the plating 1200 removed via laser ablation are etched away, e.g., via chemical or plasma etching as conventional in the art) as illustrated in Figure 6: the figure shows that the leads located at the areas 120 are removed, thus increasing the (creepage) distance between neighboring leads 12B.

It is noted that, even in a "customized" device 10 as exemplified in Figure 3, the wire bonding pattern formed in step 104 may be the same wire bonding pattern provided in a "standard" device as exemplified in Figure 2, so that the solution described herein will have a reduced impact on the whole assembly flow.

Blocks 114, 116 and 118 are exemplary of steps where the etched back surface is cleaned (via water jet or plasma cleaning) in order to improve lead wettability, with subsequent laser marking and final singulation to provide individual devices 10.

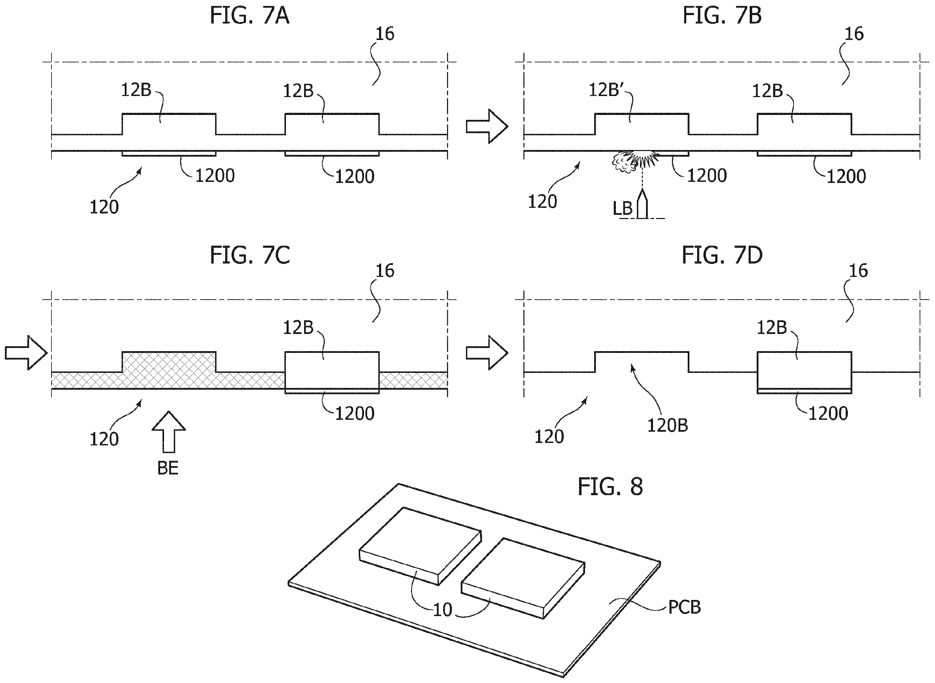

The effects of selective laser ablation in step 110 and back etching in step 122 are further exemplified in Figures 7A to 7D.

Figure 7A shows the leadframe material (at the bottom of the figure) having a masking layer 1200 (e.g., NiPdAu plating) selectively provided at those locations where leads (or other electrically conductive formations) 12B are intended to be provided in a standard full lead lay-out for a semiconductor device as exemplified in Figure 2.

Figure 7B shows the plating 1200 selectively removed via laser beam LB in those areas or regions 120 where leads 12B' are intended to be removed in a customized lead lay-out as exemplified in Figure 3, e.g., to facilitate achieving desired creepage performance.

Figure 7C shows back etching BE being applied (block 112 in Figure 4).

Figure 7D shows that, as a result of back etching BE, those regions or areas of the leadframe material (e.g., copper) that are unmasked (that is are left exposed by the masking layer 1200), including those where the plating 1200 was removed via laser ablation, are etched away.

The lead or leads 12B' located at the areas 120 are thus removed increasing the (creepage) distance between non-etched neighboring leads 12B that remain in place as desired thus providing a customized lead lay-out as exemplified in Figure 3. The insulated distance between these neighboring leads can thus be appreciably increased, which may result is a notable improvement in terms of creepage distance.

As visible in Figure 7D, recessed/depressed areas ("dimples") 120B in the encapsulation 16 remain as "testimonials" of the leads 12B' that were removed.

Figures 7A to 7B (where the semiconductor die or dice 14 and the associated wire bonding are not illustrated for simplicity) are thus exemplary of the masking layer 1200 being removed from at least one of the leads, namely the lead indicated by 12B' in the array electrically conductive leads 12B in the leadframe.

The lead or leads 12B' (or other electrically conductive formations) are thus left uncovered by the masking layer 1200 so that, when applying (back) etching to the second (back) surface of the substrate this or these leads 12B' or formations left uncovered by the (laser ablated) masking layer 1200 are removed, advantageously leaving recessed portions 120B in the encapsulation.

These recessed portions 120B further increase the (creepage) distance between non-etched neighboring leads by providing a longer (developed) distance over the surface of the encapsulation between non-etched neighboring leads, compared to the situation where some leads would be absent from leadframe by design.

Devices 10 as resulting from singulation (block 118 in Figure 4) can be arranged onto a support substrate such as a printed circuit board, PCB via a pick-and-place tool to provide a system as exemplified in Figure 8.

Figure 8 is exemplary of arranging one or more devices 10 (e.g., QFN multi-row packages) on a support substrate such as a printed circuit board, PCB to provide a system with improved creepage distance.

Such a system can be advantageously used in order to counter undesired "short" events. This may be the case in the automotive sector, for instance, where such events may have serious consequences.

## Claims

1. A method, comprising, in an ordered sequence, the steps of:
arranging (102) at least one semiconductor chip (14) on a first surface of a substrate (12A, 12B), the substrate comprising electrically conductive formations (12B) covered by a masking layer (1200) at a second surface opposite the first surface,
providing (106) an insulating encapsulation (16) of the at least one semiconductor chip (14) arranged on the first surface of the substrate (12A, 12B),
removing (110) the masking layer (1200) from at least one (12B') of the electrically conductive formations (12B) at the second surface of the substrate (12A, 12B) wherein said at least one (12B') of the electrically conductive formations (12B) is left uncovered by the masking layer (1200), and
applying (112) etching to the second surface of the substrate (12A) wherein the at least one (12B') of the electrically conductive formations (12B) left uncovered by the masking layer (1200) is removed.

2. The method of claim 1, wherein removing (110) the masking layer (1200) from at least one (12B') of the electrically conductive formations (12B) at the second surface of the substrate (12A, 12B) comprises laser ablating said masking layer (1200) from at least one (12B') of the electrically conductive formations (12B) at the second surface of the substrate (12A, 12B).

3. The method of claim 1 or claim 2, wherein the masking layer (1200) is a NiPdAu layer.

4. The method of any of claims 1 to 3, wherein the substrate comprises at least one semiconductor chip (14) mounting area (12A) at the first surface of a substrate (12A, 12B) and the electrically conductive formations (12B) comprise an array of electrically conductive leads around the said semiconductor chip (14) mounting area (12A) .

## Patentansprüche

1. Verfahren, das in einer geordneten Reihenfolge die Schritte umfasst zum:
Anordnen (102) mindestens eines Halbleiterchips (14) auf einer ersten Oberfläche eines Substrats (12A, 12B), wobei das Substrat elektrisch leitfähige Formationen (12B) umfasst, die von einer Maskierungsschicht (1200) an einer der ersten Oberfläche gegenüberliegenden zweiten Oberfläche abgedeckt sind,
Bereitstellen (106) einer isolierenden Einkapselung (16) des mindestens einen Halbleiterchips (14), die auf der ersten Oberfläche des Substrats (12A, 12B) angeordnet ist,
Entfernen (110) der Maskierungsschicht (1200) von mindestens einer (12B') der elektrisch leitfähigen Formationen (12B) an der zweiten Oberfläche des Substrats (12A, 12B), wobei die mindestens eine (12B') der elektrisch leitfähigen Formationen (12B) von der Maskierungsschicht (1200) unbedeckt bleibt, und
Anwenden (112) von Ätzen auf die zweite Oberfläche des Substrats (12A), wobei die mindestens eine (12B') der von der Maskierungsschicht (1200) unbedeckt gelassenen elektrisch leitfähigen Formationen (12B) entfernt wird.

2. Verfahren nach Anspruch 1, wobei Entfernen (110) der Maskierungsschicht (1200) von mindestens einer (12B') der elektrisch leitfähigen Formationen (12B) an der zweiten Oberfläche des Substrats (12A, 12B) das Laserabtragen der Maskierungsschicht (1200) von mindestens einer (12B') der elektrisch leitfähigen Formationen (12B) an der zweiten Oberfläche des Substrats (12A, 12B) umfasst.

3. Verfahren nach Anspruch 1 oder Anspruch 2, wobei die Maskierungsschicht (1200) eine NiPdAu-Schicht ist.

4. Verfahren nach einem der Ansprüche 1 bis 3, wobei das Substrat mindestens einen Montagebereich (12A) für einen Halbleiterchip (14) an der ersten Oberfläche eines Substrats (12A, 12B) umfasst und die elektrisch leitfähigen Formationen (12B) ein Array an elektrisch leitfähiger Leitungen um den Montagebereich (12A) für einen Halbleiterchip (14) herum umfassen.

## Revendications

1. Procédé comprenant, en une suite ordonnée, les étapes suivantes :
placer (102) au moins une puce à semiconducteur (14) sur une première surface d'un substrat (12A, 12B), le substrat comprenant des formations électriquement conductrices (12B) couvertes d'une couche de masquage (1200) sur une deuxième surface à l'opposé de la première surface,
fournir (106) une encapsulation isolante (16) de ladite au moins une puce à semiconducteur (14) placée sur la première surface du substrat (12A, 12B),
retirer (110) la couche de masquage (1200) d'au moins l'une (12B') des formations électriquement conductrices (12B) sur la deuxième surface du substrat (12A, 12B), ladite au moins une (12B') des formations électriquement conductrices (12B) étant laissée non couverte par la couche de masquage (1200), et
appliquer (112) une gravure à la deuxième surface du substrat (12A), dans laquelle ladite au moins une (12B') des formations électriquement conductrices (12B) laissée non couverte par la couche de masquage (1200) est retirée.

2. Procédé selon la revendication 1, dans lequel la suppression (110) de la couche de masquage (1200) d'au moins l'une (12B') des formations électriquement conductrices (12B) sur la deuxième surface du substrat (12A, 12B) comprend une opération d'ablation par laser de ladite couche de masquage (1200) d'au moins l'une (12B') des formations électriquement conductrices (12B) sur la deuxième surface du substrat (12A, 12B).

3. Procédé selon la revendication 1 ou 2, dans lequel la couche de masquage (1200) est une couche de NiPdAu.

4. Procédé selon l'une quelconque des revendications 1 à 3, dans lequel le substrat comprend au moins une zone de montage (12A) de puce à semiconducteur (14) sur la première surface d'un substrat (12A, 12B) et les formations électriquement conductrices (12B) comprennent un ensemble de conducteurs électriques autour de ladite zone de montage (12A) de puce à semiconducteur (14).
